# EUROPEAN PATENT SPECIFICATION

(11) **EP 1 819 523 B1**
(45) Date of publication and mention of the grant of the patent: **11.03.2009**
(21) Application number: 05824363.5
(22) Date of filing: 08.12.2005
(51) Int. Cl.: B41N 1/24, B41M 1/12

(54) **PRINTING SCREENS, MACHINE AND METHOD FOR SCREEN PRINTING**
DRUCKSIEBE, SIEBDRUCKMASCHINE UND -VERFAHREN
ECRANS D'IMPRESSION, MACHINE ET PROCEDE POUR SERIGRAPHIE

(30) Priority: 09.12.2004 GB 0427004
(43) Date of publication of application: 22.08.2007
(73) Proprietor: DEK International GmbH, 8005 Zürich (CH)
(72) Inventor: ZAHN, Michael, Dek Germany GmbH, 61118 Bad Vilbel (DE)
(74) Representative: Boden, Keith McMurray
(86) International application number: PCT/EP2005/013163
(87) International publication number: WO 2006/061223

(56) References cited:
- GB-A- 816 434
- US-A- 5 948 466
- US-A1- 2003 041 752

## Description

The present invention relates to a printing screen, often alternatively referred to as a printing stencil, for use in printing printing media, typically a solder paste or an adhesive, onto a workpiece, typically a printed circuit board.

There is an increasing requirement for such printing screens to carry a code, in order to allow for traceability in the manufacturing process, and also provide information regarding the printing screen, for example, information identifying the pattern of printing apertures, the date of manufacture, the thickness, and the extent of aperture reduction.

To date, such codes have been applied to printing screens by fixing an adhesive label, onto which the code is printed, onto a surface of the printing screen, printing the code directly onto a surface of the printing screen, or etching the code into a surface of the printing screen.

These means of applying a code to a printing screen are effective, but printed codes, where printed on labels or directly onto printing screens, suffer from the problem that the codes degrade or are even removed when cleaning the printing screens, unless protected by a protective coat, and etched codes have a low contrast which can make reading the codes difficult.

Also, such means of applying codes provide that the code can only be read from one side of the printing screen, corresponding to the surface to which the code is applied.

US-A-2003/0041752 discloses a silk printing screen having electronic storage means thereon for storing printing parameters.

The present inventor has recognized that a much improved code can be provided by forming the code so as to extend through the printing screen, such as by cutting, in the same manner as the printing apertures of existing printing screens. With such a configuration, the code can be read from either side of the printing screen, exhibits a high contrast which facilitates reading, and allows for cleaning, even by scrubbing and with aggressive cleaning agents.

In one aspect the present invention provides a printing screen for use in printing a pattern of deposits onto a workpiece, the printing screen comprising a sheet including a code element therein, wherein the code element comprises a plurality of code apertures which extend through the sheet and together define a code, which can be read by a code reader from either surface of the sheet.

Preferably, the code apertures are located at positions within a two-dimensional array, with the positioning of the code apertures in the array defining an information content of the code.

More preferably, the code apertures are located at positions within the array which correspond to regions defined between adjacent intersecting grid elements.

Yet more preferably, the grid elements extend orthogonally to one another.

In one embodiment the array is a regular array.

In one embodiment the code apertures are rectangular in shape.

In one embodiment the sheet is formed of metal.

In another embodiment the sheet is formed of synthetic material.

Preferably, the sheet includes a plurality of printing apertures which together define a pattern which corresponds to a pattern of deposits to be printed with the printing screen.

In another aspect the present invention provides a printing screen unit, comprising: a frame; and the above-described printing screen mounted to the frame.

In one embodiment the printing screen is fixedly mounted to the frame.

In another embodiment the printing screen is releasably mounted to the frame.

In a further aspect the present invention provides a screen printing machine for receiving the above-described printing screen or printing screen unit, the screen printing machine comprising a printer which is operable to print deposits of a printing medium onto a workpiece, and a control unit which is operative to image and interpret the code element in the printing screen to obtain information regarding the printing screen, and control the operation of the printer based in part on the information regarding the printing screen.

In a still further aspect the present invention provides a method of screen printing deposits of a printing medium onto a workpiece, comprising the steps of: providing the above-described printing screen or printing screen unit; imaging the code element in the printing screen; interpreting the imaged code element to obtain information regarding the printing screen; and operating a printer based in part on the information regarding the printing screen.

A preferred embodiment of the present invention will now be described hereinbelow by way of example only with reference to the accompanying drawings, in which:
Figure 1 illustrates a printing screen unit including a printing screen in accordance with a preferred embodiment of the present invention and a control unit of a screen printing machine which operates with the printing screen unit;
Figure 2 illustrates a fragmentary plan view of the printing screen of the printing screen unit of Figure 1; and
Figure 3 illustrates a plan view of a region (region A in Figure 2) of the printing screen of the printing screen unit of Figure 1.

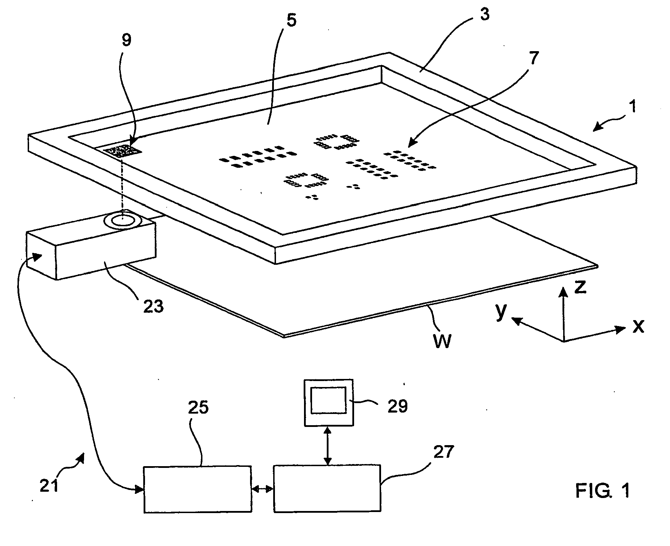

Referring to Figure 1, Figure 1 illustrates a printing screen unit 1 in accordance with a preferred embodiment of the present invention.

The printing screen unit 1 comprises a frame 3, in this embodiment rectangular in shape, and a printing screen 5 which is mounted to the frame 3. In one embodiment the printing screen 5 can be releasably mounted to the frame 3. In another embodiment the printing screen 5 could be fixedly mounted to the frame 3, for example, by means of an adhesive.

In this embodiment the printing screen 5 comprises a metal sheet, typically a stainless steel sheet. In an alternative embodiment the printing screen 5 could comprise a plastics sheet.

The printing screen 5 includes a plurality of printing apertures 7, which each extend through the printing screen 5 and together define a pattern which corresponds to the pattern of deposits to be printed onto an underlying workpiece.

The printing screen 5 further includes a code element 9, which comprises a plurality of code apertures 11 which each extend through the printing screen 5 and together define a code, which can be read by a code reader, as will be described in more detail hereinbelow.

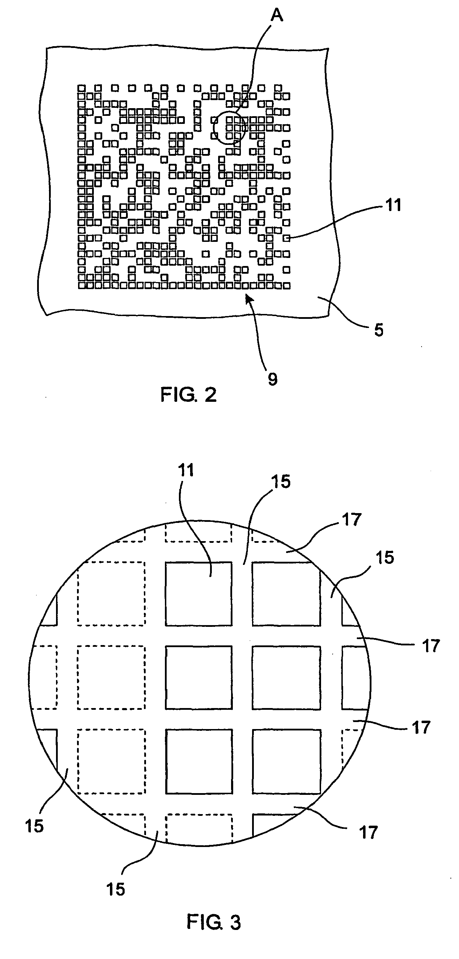

As illustrated in Figures 2 and 3, in this embodiment the code element 9 represents a two-dimensional data matrix code which contains information regarding the printing screen 5, for example, information identifying the pattern of the printing apertures 5, the date of manufacture, the thickness, and the extent of aperture reduction. In terms of the information content which can be contained by a two-dimensional data matrix code, a 24 x 24 code can store 52 alphanumeric characters, and larger arrays can typically store up to 2000 characters.

In this embodiment the code apertures 11 are located at positions within a regular array, with the positioning of the code apertures 11 defining the information content of the code element 9. It will be understood that the array in which the code apertures 11 are located can have any arrangement, where the image processing is such as to map the imaged code apertures 11 relative to the predefined array.

In this embodiment the code apertures 11 are located at positions in a rectangular array, here following the form of a Data Matrix ECC 200 code, which correspond to the regions defined between adjacent intersecting, orthogonal grid elements 15, 17. For the purposes of understanding, the regions which do not include code apertures 11 are represented in phantom.

In this embodiment the code apertures 11 are rectangular in shape, but could be of other shape, such as circular.

Referring again to Figure 1, Figure 1 also illustrates a control unit 21 of a screen printing machine in accordance with a preferred embodiment of the present invention.

The control unit 21 comprises an imaging unit 23, in this embodiment a camera, which is movable in the x-y plane between the printing screen 5 and a workpiece W which is disposed beneath the printing screen 5, when the printing screen 5 is separated from the workpiece W to allow for image acquisition.

In common with existing screen printing machines, the imaging unit 23 is utilized to image alignment marks on the printing screen 5 and the workpiece W, in order to allow for mutual alignment, and printing apertures 7 in the printing screen 5 and the resulting printed deposits on the workpiece W, in order to allow for characterization of the printing apertures 7 in the printing screen 5, such as for blockage, and the printed deposits on the workpiece W, such as for percentage coverage.

In this embodiment, in addition, the imaging unit 23 is utilized to acquire an image of the code apertures 11, which define the code element 9, in the printing screen 5, thus acquiring an image of the code element 9.

The control unit 21 further comprises an image processing unit 25 which is operative to analyze the images as acquired by the imaging unit 23 to determine the position of the alignment marks, determine the required characteristics of printing apertures 7 in the printing screen 5 and the printed deposits on the workpiece W, and interpret the code element 9 in the printing screen 5.

The control unit 21 further comprises a printer control unit 27 which is operative to control the operation of the printer (not illustrated) of the screen printing machine based in part on the information content of the code element 9 in the printing screen 5.

The control unit 21 further comprises an operator interface 29 which allows for operator control of the printer control unit 27.

In this embodiment the image processing unit 25 and the printer control unit 27 are provided by software modules within a conventional computer, typically a PC, but in another embodiment could be provided by separate hardware units.

In use, the printing screen unit 1 is disposed within a screen printing machine, and, in operation of the screen printing machine, the control unit 21 of the screen printing machine is operative through the imaging unit 23 and the image processing unit 25 to interpret the code element 9 in the printing screen 5 of the printing screen unit 1, and through the printer control unit 27 to control the operation of the printer of the screen printing machine based in part on the information content of the code element 9 in the printing screen 5.

Also, when the printing screen unit 1 is mounted in a screen printing machine, or located outside of a screen printing machine, a hand-held scanner can be used to acquire an image of the code element 9, thus providing for interpretation of the code element 9. Where mounted in a screen printing machine, the upper surface of the printing screen 5 will be exposed, which, by virtue of the code apertures 11 of the code element 9 extending through the printing screen 5, includes the code element 9. Where mounted outside of a screen printing machine, the code element 9 can be read from either side of the printing screen 5, again by virtue of the code apertures 11 of the code element 9 extending through the printing screen 5.

Finally, it will be understood that the present invention has been described in its preferred embodiment and can be modified in many different ways without departing from the scope of the invention as defined by the appended claims.

For example, in the described embodiment the imaging unit 23 is a camera, but could alternatively be a scanner.

## Claims

1. A printing screen for use in printing a pattern of deposits onto a workpiece, the printing screen comprising a sheet including a code element (9) therein, wherein the code element (9) comprises a plurality of code apertures (11) which extend through the sheet and together define a code, which can be read by a code reader from either surface of the sheet.

2. The printing screen of claim 1, wherein the code apertures (11) are located at positions within a two-dimensional array, with the positioning of the code apertures (11) in the array defining an information content of the code.

3. The printing screen of claim 2, wherein the code apertures (11) are located at positions within the array which correspond to regions defined between adjacent intersecting grid elements (15, 17).

4. The printing screen of claim 3, wherein the grid elements (15, 17) extend orthogonally to one another.

5. The printing screen of any of claims 1 to 4, wherein the array is a regular array.

6. The printing screen of any of claims 1 to 5, wherein the code apertures (11) are rectangular in shape.

7. The printing screen of any of claims 1 to 6, wherein the sheet is formed of metal.

8. The printing screen of any of claims 1 to 6, wherein the sheet is formed of synthetic material.

9. The printing screen of any of claims 1 to 8, wherein the sheet includes a plurality of printing apertures (7) which together define a pattern which corresponds to a pattern of deposits to be printed with the printing screen.

10. A printing screen unit, comprising:
a frame (3); and
the printing screen (5) of any of claims 1 to 9 mounted to the frame (3).

11. The printing screen unit of claim 10, wherein the printing screen (5) is fixedly mounted to the frame (3).

12. The printing screen unit of claim 10, wherein the printing screen (5) is releasably mounted to the frame (3).

13. A screen printing machine for receiving the printing screen (5) of any of claims 1 to 9 or the printing screen unit (1) of any of claims 10 to 12, the screen printing machine comprising a printer which is operable to print deposits of a printing medium onto a workpiece, and a control unit (21) which is operative to image and interpret the code element (9) in the printing screen (5) to obtain information regarding the printing screen (5), and control the operation of the printer based in part on the information regarding the printing screen (5).

14. A method of screen printing deposits of a printing medium onto a workpiece, comprising the steps of:
providing the printing screen (5) of any of claims 1 to 9 or the printing screen unit (1) of any of claims 10 to 12;
imaging the code element (9) in the printing screen (5);
interpreting the imaged code element (9) to obtain information regarding the printing screen (5); and operating a printer based in part on the information regarding the printing screen (5).

## Patentansprüche

1. Drucksieb zur Verwendung beim Drucken eines Musters von Ablagerungen auf ein Werkstück, wobei das Drucksieb eine Platte mit einem Code-Element (9) darauf aufweist, wobei das Code-Element (9) eine Anzahl von Code-Öffnungen (11) enthält, die sich über die Platte erstrecken und zusammen einen Code definieren, der von einem Code-Leser von einer der beiden Oberflächen der Platte gelesen werden kann.

2. Drucksieb nach Anspruch 1, wobei die Code-Öffnungen (11) an Positionen innerhalb einer zweidimensionalen Anordnung angeordnet sind, wobei die Positionierung der Code-Öffnungen (11) in der Anordnung einen Gehalt der Informationen des Codes bestimmt.

3. Drucksieb nach Anspruch 2, wobei die Code-Öffnungen (11) an Positionen innerhalb der Anordnung angeordnet sind, die Bereichen entsprechen, die zwischen angrenzenden, sich kreuzenden Rasterelementen (15, 17) bestimmt sind.

4. Drucksieb nach Anspruch 3, wobei die Rasterelemente (15, 17) sich orthogonal zueinander erstrecken.

5. Drucksieb nach einem der Ansprüche 1 bis 4, wobei die Anordnung eine regelmäßige Anordnung ist.

6. Drucksieb nach einem der Ansprüche 1 bis 5, wobei die Code-Öffnungen (11) eine rechteckige Gestalt aufweisen.

7. Drucksieb nach einem der Ansprüche 1 bis 6, wobei die Platte aus einem Metall gebildet ist.

8. Drucksieb nach einem der Ansprüche 1 bis 6, wobei die Platte aus einem synthetischen Material gebildet ist.

9. Drucksieb nach einem der Ansprüche 1 bis 8, wobei die Platte eine Anzahl an Drucköffnungen (7) aufweist, die zusammen ein Muster definieren, das einem Muster an Ablagerungen entspricht, die mit dem Drucksieb gedruckt werden sollen.

10. Drucksiebeinheit mit:
einem Rahmen (3) und
dem Drucksieb (5) nach einem der Ansprüche 1 bis 9, das an dem Rahmen (3) angebracht ist.

11. Drucksiebeinheit nach Anspruch 10, wobei das Drucksieb (5) starr an dem Rahmen (3) angebracht ist.

12. Drucksiebeinheit nach Anspruch 10, wobei das Drucksieb (5) lösbar an dem Rahmen (3) angebracht ist.

13. Siebdruckmaschine zum Aufnehmen des Drucksiebes (5) nach einem der Ansprüche 1 bis 9 oder der Drucksiebeinheit (1) nach einem der Ansprüche 10 bis 12, wobei die Siebdruckmaschine (1) einen Drucker, der die Fähigkeit aufweist, Ablagerungen eines Druckmittels auf ein Werkstück zu drucken, und eine Steuereinheit (21) umfasst, die die Fähigkeit aufweist, das Code-Element (9) in dem Drucksieb (5) abzubilden und auszuwerten, um Informationen hinsichtlich des Drucksiebes (5) zu erhalten und um den Betrieb des Druckers teilweise basierend auf diesen Informationen hinsichtlich des Drucksiebes (5) zu steuern.

14. Verfahren zum Siebdrucken von Ablagerungen eines Druckmittels auf ein Werkstück, wobei das Verfahren die Schritte aufweist:
ein Bereitstellen des Drucksiebes (5) nach einem der Ansprüche 1 bis 9 oder der Drucksiebeinheit (1) nach einem der Ansprüche 10 bis 12,
ein Abbilden des Code-Elementes (9) in dem Drucksieb (5),
ein Auswerten des abgebildeten Code-Elementes (9), um Informationen hinsichtlich des Drucksiebes (5) zu erhalten, und
ein Betreiben eines Druckers teilweise basierend auf diesen Informationen hinsichtlich des Drucksiebes (5).

## Revendications

1. Écran d'impression destiné à être utilisé pour imprimer un motif de dépôts sur une pièce à travailler, l'écran d'impression comprenant une feuille contenant un élément de code (9), dans lequel l'élément de code (9) comprend une pluralité d'ouvertures de code (11) s'étendant à travers la feuille et définissant ensemble un code qui peut être lu par un lecteur de code depuis l'une des surfaces de la feuille.

2. Écran d'impression selon la revendication 1, dans lequel les ouvertures de code (11) sont situées dans des positions dans un réseau bidimensionnel, le positionnement des ouvertures de code (11) dans le réseau définissant un contenu d'information du code.

3. Écran d'impression selon la revendication 2, dans lequel les ouvertures de code (11) sont situées dans des positions dans le réseau correspondant aux régions définies entre des éléments de grille adjacents se croisant (15, 17).

4. Écran d'impression selon la revendication 3, dans lequel les éléments de grille (15, 17) s'étendent perpendiculairement l'un à l'autre.

5. Écran d'impression selon l'une quelconque des revendications 1 à 4, dans lequel le réseau est un réseau régulier.

6. Écran d'impression selon l'une quelconque des revendications 1 à 5, dans lequel les ouvertures de code (11) sont de forme rectangulaire.

7. Écran d'impression selon l'une quelconque des revendications 1 à 6, dans lequel la feuille est formée de métal.

8. Écran d'impression selon l'une quelconque des revendications 1 à 6, dans lequel la feuille est formée de matériau synthétique.

9. Écran d'impression selon l'une quelconque des revendications 1 à 8, dans lequel la feuille comprend une pluralité d'ouvertures d'impression (7) définissant ensemble un motif correspondant à un motif de dépôts devant être imprimés avec l'écran d'impression.

10. Unité d'écran d'impression, comprenant :
un cadre (3) ; et
l'écran d'impression (5) selon l'une quelconque des revendications 1 à 9 monté sur le cadre (3).

11. Unité d'écran d'impression selon la revendication 10, dans laquelle l'écran d'impression (5) est monté de manière fixe sur le cadre (3).

12. Unité d'écran d'impression selon la revendication 10, dans laquelle l'écran d'impression (5) est monté de manière amovible sur le cadre (3).

13. Machine de sérigraphie destinée à recevoir l'écran d'impression (5) selon l'une quelconque des revendications 1 à 9 ou l'unité d'écran d'impression (1) selon l'une quelconque des revendications 10 à 12, la machine de sérigraphie comprenant une imprimante utilisable pour imprimer des dépôts d'un élément d'impression sur une pièce à travailler, et une unité de commande (21) opérationnelle pour imager et interpréter l'élément de code (9) dans l'écran d'impression (5) pour obtenir des informations concernant l'écran d'impression (5), et commander le fonctionnement de l'imprimante en partie selon les informations concernant l'écran d'impression (5).

14. Procédé de sérigraphie de dépôts d'un élément d'impression sur une pièce à travailler, comprenant les étapes consistant à :
fournir l'écran d'impression (5) selon l'une quelconque des revendications 1 à 9 ou l'unité d'écran d'impression (1) selon l'une quelconque des revendications 10 à 12 ;
imager l'élément de code (9) dans l'écran d'impression (5) ;
interpréter l'élément de code imagé (9) pour obtenir les informations concernant l'écran d'impression (5) ; et
utiliser une imprimante en partie selon les informations concernant l'écran d'impression (5).
